# EUROPEAN PATENT APPLICATION

(11) **EP 1 418 613 A1**
(43) Date of publication of application: **12.05.2004**
(21) Application number: 02447213.6
(22) Date of filing: 08.11.2002
(51) Int. Cl.: H01L 21/28, H01L 21/3213, H01L 21/3065, H01L 21/308

(54) **Etching method for manufacturing a semiconductor device**

(71) Applicant: INTERUNIVERSITAIR MICROELEKTRONICA CENTRUM ( IMEC), 3001 Leuven (BE)
(72) Inventor: Beckx, Stephan, B-3001 LEUVEN (BE); Vanhaelemeersch, Serge, B-3001 Leuven (BE)
(74) Representative: Van Malderen, Joelle

(57) **Abstract**

Method for the manufacturing of a semiconductive device comprising a gate electrode layer, a hard mask layer and an inorganic anti-reflective layer, said layers being protected in a first region by a photoresist and unprotected in a second region, comprising a first step of removing the non photoresist protected anti-reflective inorganic layer, hard mask layer and gate electrode layer in the second region; a second step of removing said photoresist on the protected region; a third step of removing said inorganic anti reflective layer in the initially photoresist protected region, wherein in said first step, only a part of said gate electrode layer is removed and that the remaining part of said layer is removed during a fourth step using the hard mask.

## Description

### Field of the invention

The present invention is related to advanced gate patterning in the field of microelectronics and in particular to a method for removing selectively anti-reflective coatings (ARC) or layers.

### Introduction and state of the art

In the last years, various techniques have been developed to extend the ability of photolithographic processes to define increasingly smaller image sizes. In that context, shorter exposure wavelengths, variable numerical aperture exposure lenses and phase shift masks have contributed to the progress in this field. At the same time, anti-reflective coatings (ARC) have been developed to enhance further critical dimension (CD) control during submicron photolithography steps. The use of such ARC layer prevents problems resulting from highly reflective underlying wafer surfaces. This reflections leads to distorted images and to a contrast reduction.

Image control problems can occur when photoresist layers are exposed over reflective surfaces such as aluminum and polycrystalline silicon for example and can be avoided by first depositing an anti-reflective coating, (ARC) prior to the application of a photoresist layer. The ARC layer should be compatible with the underlying layers, the photoresist and the wavelength of the exposure source.

SiON is one of the candidates used for advanced gate patterning as an anti-reflecting layer for the lithography step. After patterning of the gate however, the remaining SiON layer must be removed. Although some techniques currently exist for the removal of this layer, it is known that for ultra-advanced devices, problems occur during the removal steps.

The route currently applied in the prior art for SiON removal is the use of a wet etch with hot phosphoric acid (H₃PO₄). This is disclosed in different documents, one of them being the document USE-6245682.

This kind of standard process is available in wet benches with a known process window, and a good selectivity towards oxide.

The drawbacks of this process are notably chemical pollution. Furthermore, wet processing is more subjected to fluctuations compared to dry etching and is fully isotropic. A dielectric material such as a nitride-containing gate will be damaged underneath the polycrystalline silicon gate. A too low selectivity towards silicon is obtained, leading to CD-loss (critical dimension) of the gates and slight damage in the source/drain areas.

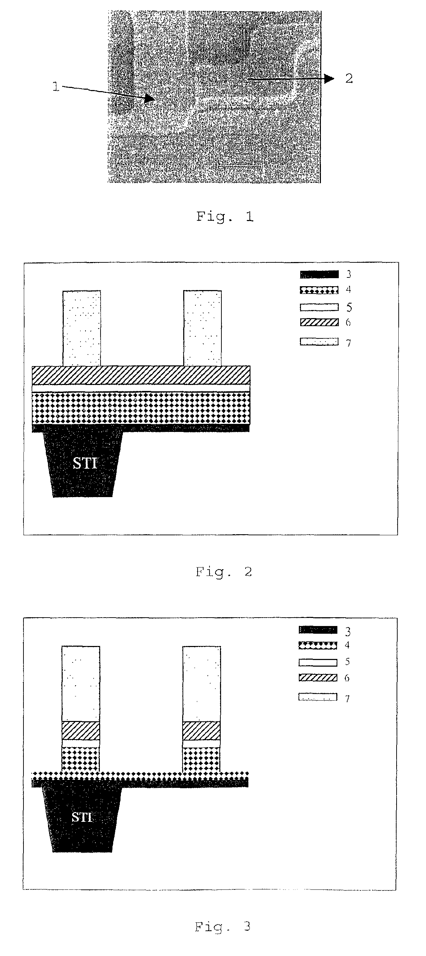

H₃PO₄ based etching process is not compatible with the use of doped gates: doped Si material is severely damaged during the wet etch by H₃PO₄. This effect is illustrated in Fig.1 - showing the result of a wet H₃PO₄ etch using a partly doped Si-gate wafer after gate patterning while the doping was performed using a resist mask.

Especially, the incompatibility with doped Si-gates makes it impossible for the wet removal step to be used for advanced gate patterning and necessitates the use of a new approach which is the object of the present invention.

As a direct alternative for the H₃PO₄ based wet removal of SiON, it has been claimed before that a diluted HF-solution at high working temperature (> 70°C) can be used. By tuning specific settings of concentration, pH and temperature, an optimal working condition can be found for the removal of SiON, while meeting the specifications.

This method exhibits good selectivity towards oxide (even though HF is an oxide etchant) and good selectivity towards undoped and doped Silicon.

Unfortunately, as already mentioned, wet processing is more subjected to fluctuations and is related to important safety issues since high temperature processing (> 70°C) is needed.

Furthermore, hardware problems have to be faced because many systems are not compatible with the process conditions, expensive hardware, and monitoring/safety detection systems have to be used.

### Aims of the present invention

The present invention aims to provide a new approach via a new process sequence for the anti-reflective layer removal without exhibiting the drawbacks of the prior art.

### Summary of the invention

The present invention is related to a method for the manufacturing of a semiconductive device comprising a gate electrode layer, a hard mask layer and an inorganic anti-reflective layer, said layers being protected in a first region by a photoresist and unprotected in a second region, comprising the following subsequent steps:
- a first step of removing the non photoresist protected anti-reflective inorganic layer, the hard mask layer and the gate electrode layer in said second region;
- a second step of removing the photoresist on the first protected region;
- a third step of removing the inorganic anti-reflective layer in the first, photoresist protected, region
characterised in that,
in said first step, only a part of the gate electrode layer is removed and that the remaining part of this layer is removed during a fourth step using the hard mask layer.

Preferably, the anti-reflective layer comprises SiON or SiC.

A preferred embodiment of said method is characterised in that said third step is performed during a dry etching process selective to the gate electrode layer.

Advantageously, the time for said fourth removing step is tuned to remove the whole anti-reflective layer, by optimising the thickness of said remaining gate electrode layer within an interferometric end-point triggering procedure.

### Short description of the drawings

Fig. 1 describes SiON removal with hot phosphoric acid as practised in the prior art.

Fig.2 describes a starting situation for a polycrystalline gate stack, wherein an additional oxide layer is inserted between the Si-gate and the SiON.

Fig. 3 describes the first etch, wherein the first poly etch part is performed.

Fig.4 describes a resist strip procedure, wherein a double strip procedure is used to remove the resist and the polymers formed during the etch process.

Fig.5 shows SiON-free samples obtained by a dedicated removal process step.

Fig.6 shows the result of a hardmask-based second poly etch approach.

### Problems to be faced

### Selectivity towards oxide

During the current available SiON removal processes, the field oxide region is fully exposed. This means that the selectivity towards oxide must be very high and no field oxide should be removed. Furthermore, selectivity towards the gate oxide is needed, even though the oxide can be removed in the active regions, there should not be any damage to the oxide underneath the polycrystalline gate (under-etching).

### Selectivity towards silicon

Selectivity towards silicon is needed for several reasons.
a) Selectivity towards source/drain regions:
   When ultra-thin gate dielectrics are used, the silicon in the source/drain regions is likely to be exposed during the SiON removal step. Since the dielectric is likely to be removed during the patterning sequence (etch and resist strip), there is a risk of silicon recess during the SiON removal step, unless the selectivity is sufficiently high.
b) Gate sidewall:
   The sidewall of the gate is exposed during the SiON removal step, a high selectivity is therefore required in order to avoid lateral damage of the gate.
c) Gate surface:
   In order to compensate for the non-uniformity of the SiON removal process, an "over etch" procedure is to be used - an additional removal step to ensure the complete removal in all areas. During this over etch step, the gate surface is exposed. In order to avoid damage to the gate, a high selectivity is required.
d) Dependency on gate doping level:
   For advanced technologies the gates will be doped (NMOS/PMOS) It is clear that the SiON removal step must show a high selectivity independent of the doping level (undoped/lowly doped/highly doped).

### Etch rate

Although there is no strict specification for the etch rate of the removal step, it is clear that a fast process is preferred to slow processes.

### Process Window/Reproducibility

The process window for any developed recipe must be high enough, so that fluctuations are minimised or will have no effect on the final result (e.g. etch rate variations). In the present invention, dry etch processing is preferred for this reason.

The present invention has developed dry etch recipes for the removal of SiON with the benefits of good process control (reproducibility) and anisotropic process limits CD-bias.

### Detailed description of the invention

Since the existing procedures all have serious drawbacks - which all seem to be unsolvable - a new procedure according to the present invention is disclosed, based on the following basic steps:
a) Using gate etch recipes that are standard available for SiON;
b) Standard approaches for the resist strip after poly etch;
c) Dry or wet SiON removal process

The new approach according to the present invention results in a dedicated removal process that meets all specifications mentioned before.

The present invention is based on the fact that a dry or wet SiON removal process is used, but in order to avoid the selectivity problems (oxide, silicon), the poly etch is split in two steps.

During a first poly etch step, only a part of the Si-gate is etched. Using an end point triggering system based on in situ thickness measurement (Interferometric Endpoint detection - IEP), automatically halts the step.

After the resist and polymer strip, a dedicated SiON removal step can be applied. Since the substrate (Source/Drain areas, Field Oxide) is not exposed at this moment - the remaining polycrystalline layer acts as a protective layer and the corresponding selectivity specifications is not an issue anymore.

After SiON-removal, the remaining polycrystalline layer is etched in a second polycrystalline etch step.

Concerning the SiON removal step, two possible embodiments are disclosed according to the present invention:
a) The use of a dedicated dry or wet etch procedure in between the resist strip and second poly etch;
b) The use of the second poly etch step to "in situ" remove the SiON layer. The time for this etch step can be tuned to remove the whole SiON layer, by optimising the thickness of the remaining gate. This can be achieved easily by tuning the IEP procedure.

When the poly etch step is split, the remaining polycrystalline layer acts as protecting layer during the SiON removal. This means that the specifications for the SiON removal step are less strict: both, selectivity towards field oxide and source/drain-silicon, become less critical.

The first poly etch step must leave a protecting poly layer which must have a controllable and reproducible thickness. This can be achieved by using the Interferometric End Point based triggering.

It is evident that the standard gate stack cannot be used in this approach. An additional oxide layer is deposited in between the Si-gate and the SiON. Since during the second poly etch step, the gate surface is reached (or even fully exposed when a dedicated SiON removal step is applied), the additional layer is needed to avoid damage to the gate.

An oxide type material is used as intermediate layer (thermal oxidation, oxide deposition).

An additional specification is set for the remaining layer thickness - after the second poly etch. Since at the moment of the highly doped drain (HDD) implantation steps (using spacers), 1 the surface of the Si-gate must be exposed, any layer that is present on top of the gate is to be removed prior to this HDD implantation step. Therefore the additional layer thickness is to be tuned so that all consecutive cleaning steps between gate patterning and HDD implant must remove the remaining layer.

### Description of a preferred embodiment of the invention

General description of the layers:
- gate electrode layer (4):
   From this layer, the gate electrode of the transistor is formed. This layer can be a silicon-based gate electrode layer or it can be based on other materials. A silicon-based layer can be a polycrystalline silicon layer, wherein the polysilicon is doped. A silicon-based layer can also be a layer comprising silicon and germanium or a layer comprising silicon and a metal such that a silicide is formed. The gate electrode layer could also comprise a metal.
- Hard mask layer (5):
   The hard mask layer could be selected, but is not limited hereto, from the group consisting of silicon oxide, silicon oxycarbide or hydrogenated silicon oxycarbide amorphous silicon oxide, amorphous silicon oxycarbide. The hard mask layer should etch slower than the gate electrode layer and must be easily removable.
- Inorganic anti-reflective layer (6):
   This layer should at least comprise an inorganic layer functioning as anti-reflective layer. The layer can be SiON or SiC. For SiON, the amounts of O and N can vary.

In the polycrystalline gate stack represented in Fig.2, an additional oxide layer 5 is inserted between the Si-gate 4 and the SiON 6. This layer is an oxide type material (thermal oxidation, oxide deposition)

Typical layer thickness ranges:
- Oxide-layer 3: determined by the technology (CMOS);
- Si-gate electrode layer 4: typically between 70 nm and 150 nm;
- additional oxide layer as hard mask 5: range of 10 nm to 50 nm;
- SiON-layer, anti reflective layer 6: determined by the lithography step - between 20 nm and 30 nm.

### First etch (resist mask based)

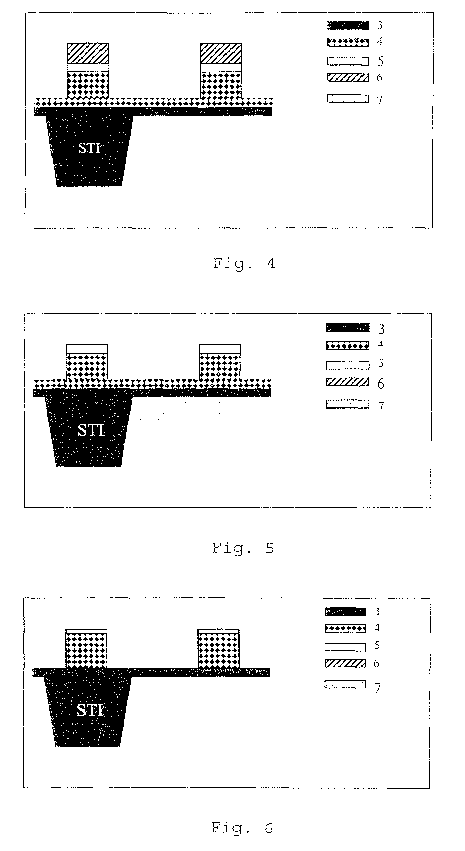

In this step represented in Fig.3, the first poly etch part is performed. The recipe patterns:
- the SiON layer 6;
- the oxide layer 5;
- most of the silicon gate electrode stack 4.

The step is stopped when a specific amount of silicon is remaining on field and active areas. The target thickness of the remaining poly layer ranges between 20 and 50 nm. The etching of a specific thickness of the poly layer is possible due to the performance of the advanced End Point Triggering system (Interferometric). This IEP system allows reproducible etching, so that a controllable remaining poly layer remains.

### Resist & Polymer Strip

Standard available resist strip procedures can be used. A double strip procedure represented in Fig.4 is used to efficiently remove the resist and polymers formed during the etch:
1) Dry Resist Ashing (02 based plasma with CF₄ addition;
2) Wet Strip - Typical Chemistry H₂SO_{4/}H₂O₂ and NH₄OH/H₂O₂.

The chemistry used during the overall resist strip procedure does not damage any of the layers exposed. Fig.5 shows the result of this process sequence in cross-section SEM analysis. During this process, the poly gate of 150 nm nominal thickness was partially etched, so that 50 nm remained after etch and resist strip. Due to insufficient contrast, no difference between the SiON and the oxide layer is visible and each layer has a thickness of 30 nm. Furthermore, a clearly sloped profile control is obtained as usual when partial etching is performed. This profile control will be corrected during the second poly etch step.

### SiON Removal using a dedicated process step

In this approach, represented in Fig.5, SiON-free samples are obtained by using a dedicated removal process.

Dry SiON removal: Currently, dry plasma etch based processes to remove SiON are available. For these processes the strictest specification is the selectivity towards doped silicon - at the gate sidewall. Silicon loss of the remaining poly layer is acceptable. Since plasma etching will be anisotropic, the risk of lateral damage is minimal.

Any thickness loss of the additional oxide layer, is caused by the amount of over etch that is given during the SiON removal step. This parameter can actually be optimised as a function of the obligatory oxide removal.

Wet SiON removal: Different chemistry combinations have been investigated to check for wet removal of the SiON layer. The use of hot phosphoric acid is not considered, since the problem with selectivity towards doped Si-gates is still valid - independent of the approach used. As an alternative, no SiON removal step is given here. This means that this layer will be present during the next etch step. This second poly etch step will remove the SiON layer in situ.

Experimental conditions for SiON removal:

| Parameter | Value |
|---|---|
| Pressure (mTor) | 120 |
| Top Power (W) | 300 |
| Bottom Power (W) | 300 |
| Ar-Flow (sccm) | 300 |
| CF4-Flow (sccm) | 15 |
| CHF3-Flow (sccm) | 30 |
| O2-Flow (sccm) | 5 |

Composition of SiON in the preferred embodiment of the present invention (experimental results)
Si : ca. 50%( range: 50 a 55%)
O . ca. 40% (range : 35 a 45%)
N : ca. 10% (range 5 a 10% )

Second poly etch (hardmask based): In this second poly etch step represented in Fig. 6, two embodiments are possible:
1) The SiON has been removed in the previous step, using a dedicated process In this case the poly etch is done using the oxide layer as hardmask.
2) The SiON layer has not been removed during the previous dedicated process step. This results in a second poly etch - which still is on a hardmask base, but now the two layers are used as masking material (oxide + SiON). This however adds the specification that the second poly etch step must remove the SiON layer. This is achieved by tuning the second poly etch.

In both options, all remaining poly gate is removed, and the hardmask layer (oxide or SiON + oxide) is partly removed.
Strict specifications exist for the remaining hardmask layer:
- It should not be completely removed, since then the poly gate would be damaged;
- Whatever is left of the oxide after the full gate patterning module is to be removed later. Therefore, the remaining oxide layer after the hardmask should be minimal: any additional HF-dip to remove this layer will also cause field oxide thinning, and may induce gate oxide under-etching. The remaining oxide thickness is to be tuned so that it is removed completely before the HDD module is reached.

The present invention makes the following processing possible:
1) First step of the poly etch;
2) Dry resist strip;
3) Wet resist strip (based on the dry strip procedure, this may be limited to a water rinse);
4) Optionally a dedicated SiON removal step;
5) Second part of the poly etch process;
6) Repeat the dry and/or wet process.

### Legend

- 1.: Doped Si gate (damaged)
- 2.: Undoped Si gate
- 3.: Oxide (field, gate)
- 4.: Gate electrode layer
- 5.: Hard mask layer
- 6.: Anti-reflective inorganic layer
- 7.: Photoresist

## Claims

1. Method for the manufacturing of a semiconductive device comprising a gate electrode layer (4), a hard mask layer (5) and an inorganic anti-reflective layer (6), said layers being protected in a first region by a photoresist (7) and unprotected in a second region, comprising the following subsequent steps:
- a first step of removing the non photoresist protected anti-reflective inorganic layer (6), the hard mask layer (5) and the gate electrode layer (4) in said second region;
- a second step of removing the photoresist (7) on the first protected region;
- a third step of removing the inorganic anti-reflective layer (6) in the first, photoresist protected, region
**characterised in that**,
in said first step, only a part of the gate electrode layer (4) is removed and that the remaining part of this layer is removed during a fourth step using the hard mask layer (5).

2. Method as in claim 1 **characterised in that** the anti-reflective layer (6) comprises SiON or SiC.

3. Method as in claim 1 **characterised in that** said third step is performed during a dry etching process selective to the gate electrode layer (4).

4. Method as in claim 1 **characterised in that** the time for said fourth removing step is tuned to remove the whole anti-reflective layer (6), by optimising the thickness of said remaining gate electrode layer (4) within an interferometric end-point triggering procedure.
